# EUROPÄISCHE PATENTSCHRIFT

(11) **EP 3 030 914 B1**
(45) Veröffentlichungstag und Bekanntmachung des Hinweises auf die Patenterteilung: **01.01.2020**
(21) Anmeldenummer: 14744590.2
(22) Anmeldetag: 30.07.2014
(51) Int. Cl.: G01R 31/28

(54) **THERMISCHE ABSCHIRMVORRICHTUNG FÜR EINE PROBECARD UND ENTSPRECHENDE PROBECARDANORDNUNG**
THERMAL SHIELDING DEVICE FOR A PROBE CARD AND CORRESPONDING PROBE CARD ASSEMBLY
DISPOSITIF DE PROTECTION THERMIQUE POUR UNE CARTE DE SONDE ET DISPOSITIF DE CARTE DE SONDE CORRESPONDANT

(30) Priorität: 09.08.2013 DE 102013215781
(43) Veröffentlichungstag der Anmeldung: 15.06.2016
(73) Patentinhaber: ERS electronic GmbH, 82110 Germering (DE)
(72) Erfinder: REITINGER, Klemens, 82110 Germering (DE)
(74) Vertreter: Isarpatent
(86) Internationale Anmeldenummer: PCT/EP2014/066387
(87) Internationale Veröffentlichungsnummer: WO 2015/018716

(56) Entgegenhaltungen:
- FR-A1- 2 645 679
- US-A1- 2008 143 364
- US-A1- 2010 052 720
- US-B2- 7 671 615

## Beschreibung

Die vorliegende Erfindung betrifft eine thermische Abschirmvorrichtung für eine Probecard und eine entsprechende Probecardanordnung.

Die US 2010/0052720 A1 offenbart eine Probecard-Anordnung mit einer ersten und zweiten Platte, einem zwischen der ersten und zweiten Platte strukturierten Kanalsystem für ein Temperierungsfluid, welches auf einer ersten Seite durch die erste Platte und auf einer zweiten Seite durch die zweite Platte begrenzt ist, einem ersten Einlass für das Temperierungsfluid in das Kanalsystem und einem ersten Auslass für das Temperierungsfluid aus dem Kanalsystem und einer Durchführungsöffnung zum Durchführen eines auf der Probecard angebrachten Nadelkopfes.

Im Fertigungsablauf bei der Produktion von integrierten Schaltungen werden Wafertests an noch nicht zerteilten Wafern durchgeführt, um fehlerhafte integrierte Schaltungen frühzeitig erkennen und aussondern zu können. Dafür wird ein zu testender Wafer in einen Wafer-Prober eingelegt und mittels eines darin befindlichen temperierbaren Chucks auf eine gewünschte Testtemperatur gebracht. Wenn sich der Wafer auf der gewünschten Testtemperatur befindet, wird mittels einer Kontaktnadelanordnung, die sich an einem Nadelkopf befindet, eine elektrische Verbindung zu den Kontaktflächen der zu testenden integrierten Schaltung erstellt. Der Nadelkopf mit den Kontaktnadeln ist auf einer sogenannten Probecard angebracht, welche eine Schnittstelle zwischen einem Testsystem und dem Wafer über die Kontaktnadeln des Nadelkopfes bildet. Üblicherweise ist die Probecard mechanisch in einem Wafer-Prober verankert und über einen Kabelstrang mit einem Testgerät verbunden. Die Probecard besteht üblicherweise aus einer gedruckten Schaltungsplatte (PCB), an der der Nadelkopf mit den Kontaktnadeln überstehend angebracht ist.

Zum Testen lässt sich der Chuck mit dem darauf befindlichen Wafer im Wafer-Prober unterhalb des Nadelkopfes seitlich und in Höhenrichtung verfahren, damit sämtliche auf dem Wafer befindlichen integrierten Schaltungen, welche zu testen sind, erreicht werden können.

Wafertests werden typischerweise im Temperaturbereich zwischen -40 °C und 200 °C durchgeführt, in Ausnahmefällen sogar bei noch extremeren Temperaturen oberhalb bzw. unterhalb des Nullpunkts.

Hierbei tritt das Problem auf, dass die Probecard einerseits durch Wärmeleitung über die Kontaktnadeln und andererseits durch Wärmestrahlung diesen extrem hohen bzw. tiefen Testtemperaturen ausgesetzt wird. Dies kann zu mechanischen und/oder elektrischen Problemen beim Testen führen.

Ein bekannter Ansatz, um Probleme bei hohen Temperaturen zu vermeiden, besteht darin, auf der Probecard Heizeinrichtungen vorzusehen, welche es ermöglichen, die Probecard auf die gewünschte Testtemperatur vorzuheizen und ggf. bei dieser Temperatur zu kalibrieren. Derartige Heizeinrichtungen sind kostspielig und bedingen bis zu 80 % der Kosten einer derartigen Probecard.

Weiterhin entstehen durch das Verfahren des Chucks unterhalb der Probecard asymmetrische Temperaturverteilungen auf der Probecard, da die Fläche der Probecard üblicherweise größer als die Fläche des Chucks mit dem darauf befindlichen Wafer ist.

Die US 7,579,847 offenbart eine Kühlanordnung für eine Probecard, wobei aktive elektronische Komponenten während eines Testbetriebs mittels eines Kühlfluids gekühlt werden.

Die US 2010/0327891 A1 offenbart ein Verfahren und eine Vorrichtung zum thermischen Konditionieren von einer Probecard, wobei eine thermische Managementvorrichtung auf der Probecard angeordnet ist, welche die Probecard erwärmen und/oder kühlen kann, wobei ein Temperatursensor, der auf der Probecard angebracht ist, mit der thermischen Managementvorrichtung verbunden ist.

Die US 7,541,824 B2 offenbart eine Probecard mit einem über aktiven elektronischen Komponenten befindlichen Luftkanal zum Kühlen der aktiven elektrischen Komponenten auf der Probecard.

Die US 7,501,844 B2 offenbart eine flüssigkeitsgekühlte Probecard mit einem Wasserblock zur Wärmedissipation auf einer Probecard-Schnittstelle zum Kühlen aktiver elektronischer Komponenten und weiterer Komponenten auf der Probecard.

PTC-Folienheizungen sind aus der WO 2008/048176 A1 und der WO 2011/040865 A1 bekannt.

Daher ist es Aufgabe der vorliegenden Erfindung, eine thermische Abschirmvorrichtung für eine Probecard und eine entsprechende Probecardanordnung zu schaffen, welche es ermöglichen, die Probecard trotz variierender Temperaturen eines darunter befindlichen Wafers im Wesentlichen konstant zu halten, und zwar vorzugsweise bei bzw. leicht über Raumtemperatur, z.B. bei 35 bis 40 °C.

Zur Lösung dieser Aufgabe schafft die vorliegende Erfindung eine thermische Abschirmvorrichtung für eine Probecard gemäß dem unabhängigen Anspruch 1 sowie eine Probecardanordnung gemäß dem unabhängigen Anspruch 13.

Bevorzugte Weiterbildungen sind Gegenstand der jeweiligen abhängigen Ansprüche.

In den Unteransprüchen finden sich vorteilhafte Weiterbildungen und Verbesserungen des betreffenden Gegenstandes der Erfindung.

Die erfindungsgemäße thermische Abschirmvorrichtung für eine Probecard nach Anspruch 1 bzw. die entsprechende Probecardanordnung nach Anspruch 12 weisen den Vorteil auf, dass die Temperatur der Probecard im Wesentlichen konstant gehalten werden kann und eine asymmetrische Temperaturverteilung auf der Probecard vermieden werden kann.

Die erfindungsgemäße Abschirmvorrichtung eignet sich zur Nachrüstung in handelsüblichen Wafer-Probern und ist leicht montierbar bzw. demontierbar. Weiterhin lässt sich die erfindungsgemäße thermische Abschirmvorrichtung vorzugsweise mit Luft als Temperierungsfluid betreiben, wobei diese Luft auch für ein entsprechendes Chucksystem des Wafer-Probers verwendet werden kann. Mit anderen Worten, ist bei derartigen Wafer-Probern die Quelle für das Temperierungsfluid in Form von Luft bereits vorhanden, und es müssen bei Nachrüstung lediglich weitere Anschlüsse bzw. Regelungsmodule für die thermische Abschirmvorrichtung bereitgestellt werden.

Die der vorliegenden Erfindung zugrunde liegende Idee besteht darin, zwischen einer ersten und einer zweiten wärmeleitfähigen Platte, welche den Wirkungsbereich der thermischen Abschirmvorrichtung festlegen, durch eine strukturierte wärmeisolierende Zwischenschicht ein Kanalsystem zu bilden, durch welches das Temperierungsfluid derart geleitet wird, dass sich die Temperaturdifferenz zur Probecard nicht zur Probecard hin ausbreiten kann. Das Kanalsystem kann zum Nadelkopf hin geschlossen sein oder eine Abzweigung zur zusätzlichen Kühlung des Nadelkopfes durch das Temperierungsfluid aufweisen.

Vorzugsweise ist das Kanalsystem derart gestaltet, dass das Temperierungsfluid darin einen Gegenstromverlauf annimmt. Dies hat den Vorteil, dass Einströmen des Temperaturfluids das bereits in dem Kanalsystem befindliche Temperierungsfluid vorkühlen kann, was den Kühleffekt noch wirksamer werden lässt.

Gemäß einer weiteren bevorzugten Weiterbildung sind der erste Einlass für das Temperierungsfluid und der erste Auslass für das Temperierungsfluid seitlich zwischen der ersten und zweiten Platte in das Kanalsystem geführt. Dies hat den Vorteil, dass keine Anschlüsse in der ersten bzw. zweiten Platte gefertigt werden müssen und dass der erste Einlass und Auslass thermisch isoliert vorgesehen werden können und zudem die Flächenwirkung der thermischen Abschirmvorrichtung nicht beeinflussen können.

Gemäß einer weiteren bevorzugten Weiterbildung sind der erste Einlass für das Temperierungsfluid durch die erste Platte und der erste Auslass für das Temperierungsfluid seitlich zwischen der ersten und zweiten Platte in das Kanalsystem geführt. Dies hat den Vorteil, dass das Temperierungsfluid durch die Probecard hindurch von oben eingeführt werden kann.

Erfindungsgemäß ist in der Zwischenschicht ein Kanal zwischen der ersten und zweiten Platte ausgebildet, durch den das Temperierungsfluid in den Bereich der Durchführungsöffnung geleitet werden kann, durch die der Nadelkopf eingeführt ist. Somit lässt sich auch seitlich der Nadelkopf kühlen, wobei vorzugsweise eine entsprechende Dichteinrichtung vorgesehen wird, die derart gestaltet ist dass sich der betreffende Teil des Temperierungsfluids zu der Nadelanordnung des Nadelkopfes ausbreiten kann, sondern vielmehr zur Rückseite des Nadelkopfes hin über die Probecard ableitbar ist.

Gemäß einer weiteren bevorzugten Ausführungsform ist eine in die Durchführungsöffnung einsetzbare Adaptervorrichtung vorgesehen, wobei die Adaptervorrichtung eine weitere Durchführungsöffnung zum Durchführen des auf der Probecard angebrachten Nadelkopfes aufweist. Dies ermöglicht eine einfache Anpassung der erfindungsgemäßen thermischen Abschirmvorrichtung an Nadelköpfe mit unterschiedlichen Durchmessern.

Gemäß einer weiteren bevorzugten Ausführungsform ist eine in die Durchführungsöffnung einsetzbare Nadelkühleinrichtung vorgesehen, durch die das Temperierungsfluid teilweise in den Nadelkopf einleitbar ist. Dies erhöht die Kühleffizienz weiter.

Gemäß einer weiteren bevorzugten Ausführungsform sind die erste und zweite Platte Metallplatten mit einer Dicke im Bereich 0,5 bis 2 mm. Besonders bevorzugt sind Kupferplatten mit einer thermisch reflektierenden Ni-Beschichtung.

Gemäß einer weiteren bevorzugten Ausführungsform ist die Zwischenschicht eine Gießharzschicht mit einer Dicke im Bereich 0,5 bis 2 mm. Eine derartige Zwischenschicht ist wirksam thermisch isolierend und lässt sich leicht strukturieren, beispielsweise durch Stanzen oder Schablonengießen.

Gemäß einer weiteren bevorzugten Ausführungsform ist ein Temperatursensor in der Zwischenschicht angeordnet, der sich mit einer der ersten und zweiten Platte in thermischem Kontakt befindet. Die Platte, mit der sich der Temperatursensor in thermischem Kontakt befindet, ist zweckmäßigerweise die der Probecard zugewandte Platte, wodurch eine effektive Regelung auf die gewünschte Solltemperatur ermöglicht wird. Ein Temperatursensor kann auch an verschiedenen Stellen im Strom des Temperierungsfluids angebracht werden, um ggfs. auf lokale Erwärmungen schnell reagieren zu können.

Gemäß einer weiteren bevorzugten Ausführungsform ist auf einer der ersten und zweiten Platte eine wärmeisolierende Abstandshaltervorrichtung angebracht, welche auf die Probecard zum Definieren eines dazwischenliegenden Luftspalts auflegbar ist. Auch diese Abstandshaltervorrichtung ist zweckmäßigerweise aus Gießharz und gewährleistet eine konstante Breite des Luftspalts, wobei eine Wärmeleitung durch die thermisch isolierende Eigenschaft der Abstandshaltervorrichtung im Wesentlichen vermieden werden kann.

Gemäß einer weiteren bevorzugten Ausführungsform ist auf einer der ersten und zweiten Platte eine PCT-Folienheizung aufgebracht. Dadurch lassen sich lokale Temperaturschwankungen beim Testen noch besser unterdrücken.

Gemäß einer weiteren bevorzugten Ausführungsform wird der Kanal, durch den das Temperierungsfluid in die Durchführungsöffnung leitbar ist, durch einen entsprechenden zweiten Kanal in einer zugehörigen Adaptervorrichtung fortgeführt, wobei eine Dichteinrichtung zwischen thermischer Abschirmvorrichtung und Adaptervorrichtung sowie eine weitere Dichteinrichtung zwischen Adaptervorrichtung und Nadelkopf derart gestaltet sind, dass dieser Teil des Temperierungsfluids nicht zur Nadelanordnung auf den Nadelkopf entweichen kann, sondern über die Rückseite des Nadelkopfes und die Probecard in den oberen Bereich des Wafer-Probers abgeführt werden kann und daraus entsprechend abgepumpt werden kann.

Gemäß einer weiteren bevorzugten Ausführungsform ist die Probecard in eine Halterung eingespannt und die thermische Abschirmvorrichtung an der Halterung angebracht. Dies vermeidet eine Wärmeleitung zwischen der thermischen Abschirmvorrichtung und der Probecard.

Ausführungsbeispiele der Erfindung sind in den Zeichnungen dargestellt und in der nachfolgenden Beschreibung näher erläutert.

Es zeigen:
- Fig. 1: eine Probecardanordnung mit einer beispielhaften thermischen Abschirmvorrichtung;
- Fig. 2: eine vergrößerte Darstellung der beispielhaften thermischen Abschirmvorrichtung;
- Fig. 3: eine horizontale Schnittdarstellung der beispielhaften thermischen Abschirmvorrichtung;
- Fig. 4: eine Probecardanordnung mit einer weiteren beispielhaften thermischen Abschirmvorrichtung;
- Fig. 5.: eine Probecardanordnung mit einer thermischen Abschirmvorrichtung gemäß einer ersten Ausführungsform der vorliegenden Erfindung;
- Fig. 6: eine vergrößerte Teildarstellung einer Probecardanordnung mit einer thermischen Abschirmvorrichtung gemäß einer zweiten Ausführungsform der vorliegenden Erfindung;
- Fig. 7: eine vergrößerte Darstellung einer weiteren beispielhaften thermischen Abschirmvorrichtung; und
- Fig. 8a),b): eine Probecardanordnung mit einer thermischen Abschirmvorrichtung gemäß einer dritten Ausführungsform der vorliegenden Erfindung, wobei Fig. 8b) eine vergrößerte Teildarstellung von Fig. 8a) ist.

In den Figuren bezeichnen gleiche Bezugszeichen gleiche oder funktionsgleiche Bestandteile.

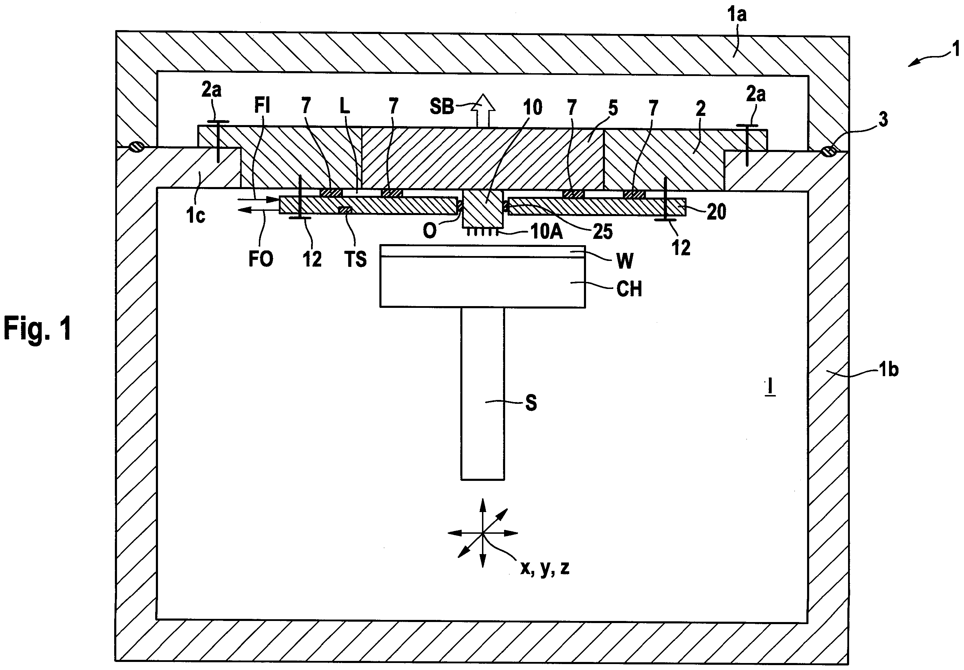

Fig. 1 zeigt eine Probecardanordnung mit einer beispielhaften thermischen Abschirmvorrichtung.

In Fig. 1 bezeichnet Bezugszeichen 1 einen Wafer-Prober, welcher ein Oberteil 1a und ein Unterteil 1b aufweist. Das Oberteil 1a ist bezüglich des Unterteils 1b aufklappbar und gegenüber letzterem mittels einer Dichteinrichtung 3 abgedichtet.

Im unteren Bereich des Wafer-Probers befindet sich ein Chuck CH, welcher mittels einer (nicht dargestellten) Temperierungseinrichtung temperierbar ist. Aufgespannt auf dem Chuck CH ist ein Wafer W. Der Chuck CH befindet sich auf einem Sockel S, welcher in x-, y-und z-Richtung verfahrbar ist. Im Unterteil 1b vorgesehen sind elektrische Anschlüsse und fluidische Anschlüsse für den Chuck CH und den Innenraum I, welche aus Gründen der Übersichtlichkeit vorliegend nicht dargestellt sind.

Im oberen Bereich des Unterteils 1b aufgehängt ist eine Probecard 5 in Form einer gedruckten Schaltungsplatte, welche in einer Halterung 2 eingeschraubt ist, die wiederum mit einem entsprechenden Ringflansch 1c des Unterteils 1b über eine Schraubeinrichtung 2a verschraubt ist.

Alternativ können auch das Oberteil 1b und der Ringflansch 1c derart konstruiert werden, dass die Probecard 5 beim Aufklappen mit nach ober schwenkt und über der Probecard 5 eine Öffnung ist, durch die die Kabel zum Tester gehen.

Auf der dem Innenraum I des Wafer-Probers 1 zugewandten Seite der Probecard 5 befindet sich ein Nadelkopf mit einer daran angebrachten Nadeleinrichtung 10A zum Kontaktieren elektronischer Schaltungen auf dem Wafer W. Der Nadelkopf 10 mit der Nadeleinrichtung 10A steht von der Probecard 5 nach unten in den Innenraum I hinein vor.

Die Halterung 2 ist üblicherweise aus Aluminium oder Stahl gefertigt, wie auch die tragenden Teile des Wafer-Probers 1.

Auf der dem Innenraum I abgewandten Seite der Probecard 5 befindet sich ein Signalleitungsbus SB, über den die Testsignale von der Probecard 5 an einen entsprechenden (nicht dargestellten) Tester weitergeleitet werden.

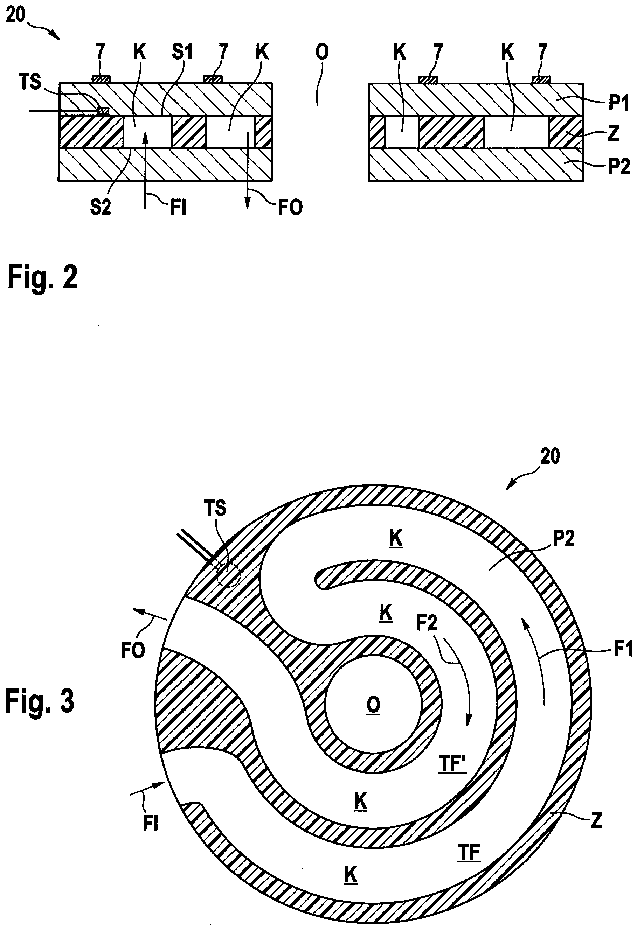

Unterhalb der Halterung 2 mit der darin eingespannten Probecard 5 vorgesehen ist eine thermische Abschirmvorrichtung 20 gemäß der ersten Ausführungsform der vorliegenden Erfindung. Die thermische Abschirmvorrichtung 20 weist eine im Wesentlichen scheibenförmige Form auf, wobei im zentralen Bereich eine Durchführungsöffnung O für den Nadelkopf 10 vorgesehen ist. Details der thermischen Abschirmvorrichtung 20 werden später mit Bezug auf Fig. 2 erläutert werden.

Der Nadelkopf 10 ist durch die Durchführungsöffnung O in den Innenraum I geführt und mittels einer Dichteinrichtung 25 abgedichtet, sodass keine Wärmestrahlung zur Probecard 5 vom Wafer W gelangen kann. Weiterhin ist die thermische Abschirmvorrichtung 20 über eine Schraubeinrichtung 12 an der Halterung 2 befestigt, sodass es keine Wärmeleitung zwischen der thermischen Abschirmvorrichtung 20 und der Probecard 5 gibt. Zum Bilden eines konstanten Luftspaltes L zwischen der thermischen Abschirmvorrichtung 20 ist eine Abstandshaltervorrichtung 7 aus Gießharz auf der thermischen Abschirmvorrichtung 20 aufgebracht. Diese Abstandshaltervorrichtung 7 wirkt wärmeisolierend, sodass die Wärmeleitung zwischen thermischer Abschirmvorrichtung 20 und Probecard 5 auch in diesem Bereich minimiert ist.

Seitlich an der thermischen Abschirmvorrichtung 20 vorgesehen sind ein erster Einlass FI für ein Temperierungsfluid, im vorliegenden Beispiel Luft, und ein erster Auslass FO für das Temperierungsfluid in Form der Luft.

Wenn beispielsweise der Wafer W zum Testen eine Temperatur von 200 °C aufweisen soll, was durch die Temperierungseinrichtung des Chucks CH bewirkt wird, so wird die thermische Abschirmvorrichtung durch das Temperierungsfluid derart geregelt, dass die Probecard im Wesentlichen auf konstanter Temperatur, beispielsweise Raumtemperatur, bleibt. Um die Regelung effektiv zu gestalten, weist die thermische Abschirmvorrichtung 20 einen Temperatursensor TS auf.

Insbesondere ist die thermische Abschirmvorrichtung 20 derart aufgebaut, dass sich die hohe Temperatur an ihrer Unterseite nicht zu ihrer Oberseite ausbreiten kann, was durch thermischen Ausgleich durch das Temperierungsfluid TF bewirkt wird.

Bei dieser Ausführungsform gibt es zwar eine gewisse Wärmeleitung während des Testens, allerdings ist diese vernachlässigbar, falls der Testzyklus nur sehr kurz ist.

Insbesondere ermöglicht es die thermische Abschirmvorrichtung 20 auch, eine asymmetrische Temperaturverteilung auf der Probecard 5 zu vermeiden, wenn der Chuck CH unterhalb des Nadelkopfes 10 verfahren wird, um an elektrische Schaltungen im Randbereich des Wafers W zu gelangen, da die thermische Abschirmvorrichtung 20 seitlich weit über die Probecard 5 hinausreicht.

Fig. 2 zeigt eine vergrößerte Darstellung der beispielhaften thermischen Abschirmvorrichtung.

Wie in Fig. 2 dargestellt, besteht die thermische Abschirmvorrichtung 20 aus einer ersten und einer zweiten wärmeleitfähigen Platte P1, P2, welche jeweils aus Kupfer sind und an ihrer Oberfläche eine Ni-Beschichtung aufweisen, welche wärmereflektierend ist.

Zwischen der ersten und zweiten wärmeleitfähigen Platte P1, P2 vorgesehen ist eine strukturierende wärmeisolierende Zwischenschicht Z aus Gießharz. Die Zwischenschicht Z bildet ein Kanalsystem K für das Temperierungsfluid, welches auf einer ersten Seite S1 durch die erste Platte P1 und einer zweiten Seite S2 durch die zweite Platte P2 begrenzt ist.

Der erste Einlass FI und der erste Auslass FO sind in Fig. 2 nur schematisch angedeutet, und können sich prinzipiell an beliebiger Stelle befinden. Bevorzugt ist, dass der erste Einlass FI und der erste Auslass FO seitlich zwischen der ersten und zweiten Platte P1, P2 in das Kanalsystem K geführt sind, beispielsweise durch kurze Rohrstummel, welche in die Zwischenschicht Z eingebettet sind.

Der Temperatursensor TS ist in Kontakt mit der ersten Platte P1, welche sich unterhalb der Probecard 5 in Fig. 1 befindet. Die Abstandshaltervorrichtung 7 aus Gießharz ist auf der Oberseite der ersten Platte P1 aufgeklebt, kann allerdings auch als separate Komponente vorgesehen werden bzw. an der Probecard 5 angebracht sein.

Die Zwischenschicht Z aus Gießharz kann beispielsweise durch Stanzen oder durch ein Siebdruckverfahren bzw. Schablonendruckverfahren hergestellt werden. Gießharz hat den zusätzlichen Vorteil, dass es eine feste Verklebung zwischen der ersten und zweiten Platte P1, P2 gewährleisten kann, also eine sehr gute Stabilität der thermischen Abschirmvorrichtung.

Allerdings ist die Zwischenschicht nicht auf das Material Gießharz beschränkt, vielmehr können auch andere wärmeisolierende Materialien, insbesondere Kunststoffe dafür verwendet werden.

Bei diesem Beispiel ist das Kanalsystem K zur Durchführungsöffnung O hin geschlossen.

Fig. 3 zeigt eine horizontale Schnittdarstellung der beispielhaften thermischen Abschirmvorrichtung.

Die Darstellung in Fig. 3 zeigt ein Beispiel für die Ausbildung des Kanalsystems K. Dieses weist im vorliegenden Fall einen Gegenstromverlauf auf, was sich insbesondere an den Pfeilen F1, F2 anschaulich zeigen lässt. Dadurch wird Temperierungsfluid TF', welches sich bereits im Kanalsystem K befindet, durch nachströmendes Temperierungsfluid TF vorgekühlt, sodass ein effektiver Wärmetausch mit der zweiten Platte P2 möglich wird, wodurch der Wärmetransport zur ersten Platte P1 äußerst gering gehalten werden kann.

Optional können Temperatursensoren im Strom des Temperierungsfluids TF, TF' vorgesehen sein.

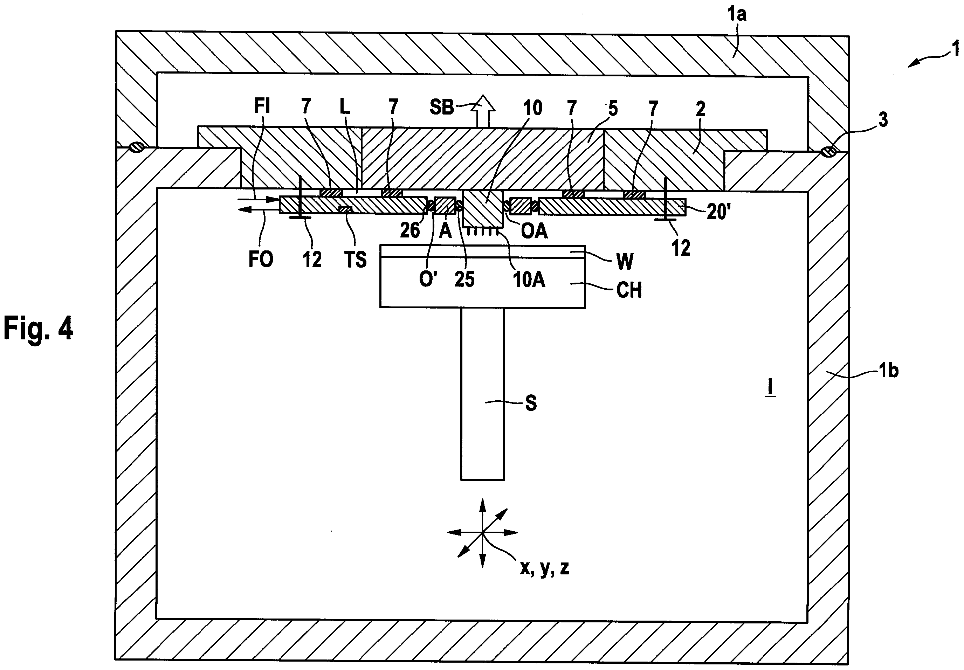

Fig. 4 zeigt eine Probecardanordnung mit einer weiteren beispielhaften thermischen Abschirmvorrichtung.

Bei der Probecardanordnung gemäß Fig. 4 ist die Durchführungsöffnung der thermischen Abschirmvorrichtung 20' mit Bezugszeichen O' bezeichnet. Sie ist größer als die Durchführungsöffnung O gemäß der oben beschriebenen ersten Ausführungsform. Um eine effektive thermische Abschirmung der Probecard 5 bei diesem Beispiel zu gewährleisten, ist zusätzlich eine Adaptervorrichtung A in die Durchführungsöffnung O' eingesetzt, welche ihrerseits eine kleinere Durchführungsöffnung OA aufweist, durch die der Nadelkopf 10 durchgeführt ist, wobei eine erste Dichteinrichtung 26 zwischen der Adaptervorrichtung A und der thermischen Abschirmvorrichtung 20' vorgesehen ist und wobei eine zweite Dichteinrichtung 25 zwischen der Adaptervorrichtung A und dem Nadelkopf 10 vorgesehen ist.

Obwohl die Adaptervorrichtung A eine passive Komponente ist, beeinträchtigt sie die Funktion der thermischen Abschirmvorrichtung 20' nicht, solange die Fläche der thermischen Abschirmvorrichtung 20' wesentlich größer als die Fläche der Adaptervorrichtung A ist, wobei in Fig. 4 diese Flächenrelation nur schematisch dargestellt ist und sich in der Realität wesentlich geringer gestaltet.

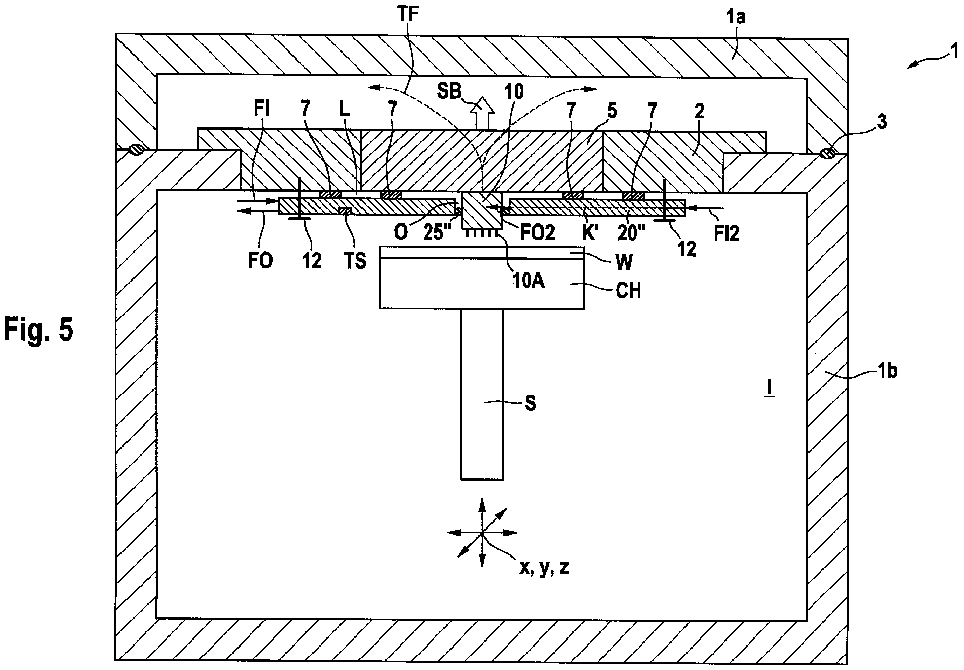

Fig. 5 zeigt eine Probecardanordnung mit einer thermischen Abschirmvorrichtung gemäß einer ersten Ausführungsform der vorliegenden Erfindung.

Bei der ersten Ausführungsform gemäß Fig. 5 weist die thermische Abschirmvorrichtung 20' einen Kanal K' zwischen der ersten und zweiten Platte P1, P2 auf, wobei ein zweiter Einlass FI2 für das Temperierungsfluid in den Kanal K' seitlich der ersten thermischen Abschirmvorrichtung 20" vorgesehen ist. Ein zweiter Auslass FO2 für das Temperierungsfluid aus dem Kanal K' ist derart vorgesehen, dass aus dem Kanal K' austretendes Temperierungsfluid auf den Nadelkopf 10 richtbar ist.

Um zu vermeiden, dass das aus dem zweiten Auslass FO2 austretende Temperierungsfluid in den Bereich der Nadeleinrichtung bzw. des Wafers W gelangt, ist die Dichteinrichtung 25" derart gestaltet, dass aus dem zweiten Auslass FO2 austretendes Temperierungsfluid zu der Nadeleinrichtung 10A hin abgedichtet ist und sich nur zur Oberseite durch die Probecard 5 hin ausbreiten kann, wie durch gepunktete Linien angedeutet.

Das in den oberen Bereich austretende Temperierungsfluid TF kann beispielsweise durch eine Pumpe abgesaugt werden.

Ansonsten ist die dritte Ausführungsform gemäß Fig. 5 analog zur oben beschriebenen ersten Ausführungsform aufgebaut.

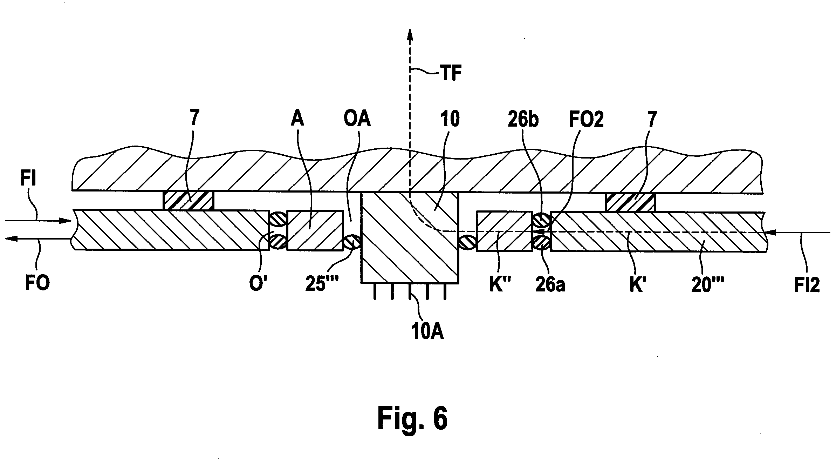

Fig. 6 zeigt eine vergrößerte Teildarstellung einer Probecardanordnung mit einer thermischen Abschirmvorrichtung gemäß einer zweiten Ausführungsform der vorliegenden Erfindung.

Bei der zweiten Ausführungsform gemäß Fig. 6 ist die Durchführungsöffnung der thermischen Abschirmvorrichtung 20'" mit O' bezeichnet, wobei bei dieser vierten Ausführungsform analog zur zweiten Ausführungsform eine Adaptervorrichtung A verwendet wird. Die Adaptervorrichtung A weist einen weiteren Kanal K" auf, durch den das aus dem zweiten Auslass FO2 austretende Temperierungsfluid auf den Nadelkopf 10 geleitet werden kann und sich von da aus zur Oberseite im Wafer-Prober 1 ausbreiten kann (vgl. Fig. 5).

Die erste Dichteinrichtung 26a, 26b besteht aus zwei Dichtringen, welche einen abgedichteten Durchtritt des Temperierungsfluids in den zweiten Kanal K" der Adaptervorrichtung A ermöglichen, und die Dichteinrichtung 25''' zwischen der Adaptervorrichtung A und dem Nadelkopf 10 ermöglicht, dass das Temperierungsfluid durch den Nadelkopf abgeführt werden kann, welcher beispielsweise, aber nicht notwendigerweise, innen hohl ausgeführt werden kann.

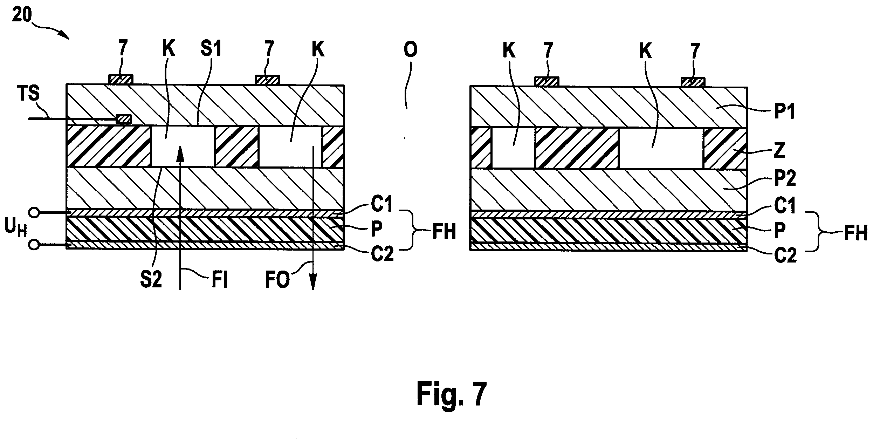

Fig. 7 ist eine vergrößerte Darstellung einer weiteren beispielhaften thermischen Abschirmvorrichtung.

Die thermische Abschirmvorrichtung gemäß Fig. 7 geht aus von der thermische Abschirmvorrichtung gemäß Fig. 2, wobei zusätzlich auf der wärmeleitfähigen Platte P2 eine PTC-Folienheizung FH aufgebracht ist.

Die PTC-Folienheizung weist zwei flächige Metallelektroden C1, C2 auf, an die eine Heizleistung über eine entsprechende Heizspannung U_{H} eingespeist wird. Zwischen den flächige Metallelektroden C1, C2 liegt eine Schicht P aus einem Polymercompound mit positivem Temperaturkoeffizienten des elektrischen Widerstands. Der Strom fließt somit vertikal durch die PTC-Folienheizung FH.

Kommt es beim Wafertesten zu einer lokalen Erwärmung aufgrund der eingekoppelten Testleistung, so tritt eine lokale Erhöhung des elektrischen Widerstands der Schicht P aus dem Polymercompound auf, die der Erwärmung entgegenwirkt, da die lokale Heizleistung reduziert wird. Es liegt also eine passive lokale Temperaturregelung vor.

Die Grundheizleistung entsprechend der Heizspannung U_{H} wird zweckmäßigerweise derart gewählt, dass die sich im Gleichgewicht von Heizen und Fluidkühlen einstellende Temperatur oberhalb der Raumtemperatur, aber deutlich unterhalb einer Temperatur liegt, bei der deutliche Einflüsse auf die Elektronik der Probecard ausgeübt werden. Beispielsweise wird 40°C als die sich im Gleichgewicht einstellende Temperatur ausgewählt, wobei eine typische Heizleistung bei 80 W liegt.

So lassen sich lokale Temperaturerhöhungen beim Testen noch besser vermeiden.

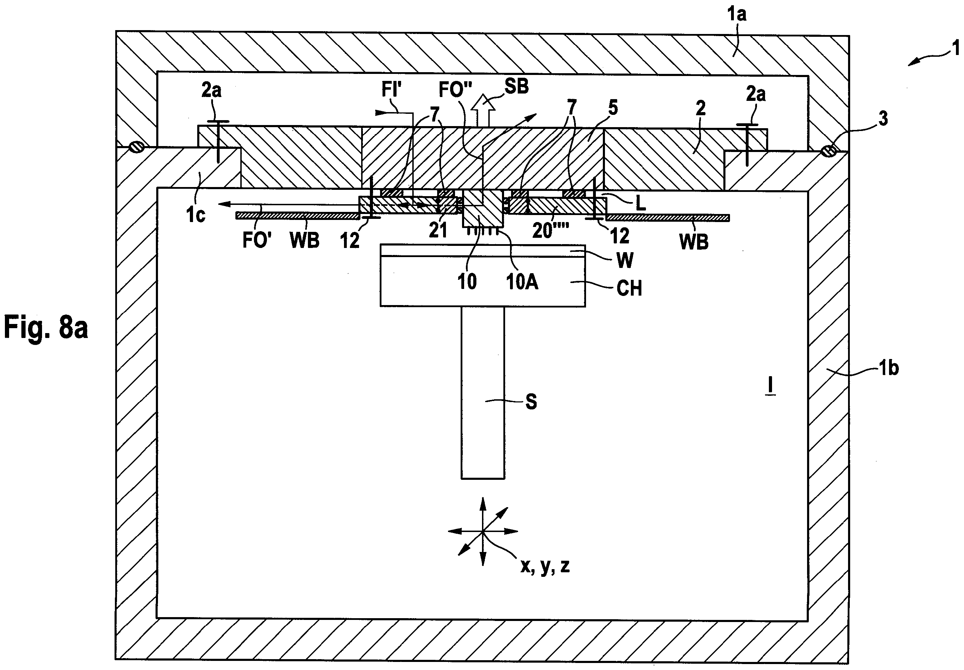

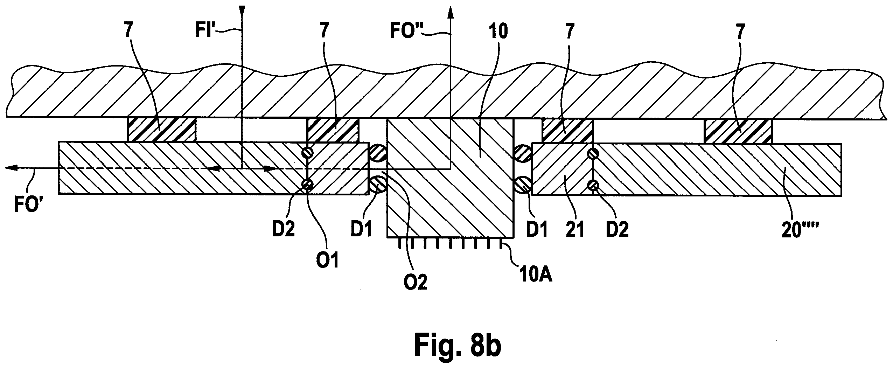

Fig. 8a),b) zeigen eine Probecardanordnung mit einer thermischen Abschirmvorrichtung gemäß einer dritten Ausführungsform der vorliegenden Erfindung, wobei Fig. 8b) eine vergrößerte Teildarstellung von Fig. 8a) ist.

Bei der sechsten Ausführungsform ist die thermische Abschirmvorrichtung mit Bezugszeichen 20"" bezeichnet. In der Durchführungsöffnung O1 ist eine einsetzbare Nadelkühleinrichtung 21 vorgesehen, durch die das Temperierungsfluid teilweise in den Nadelkopf 10 einleitbar ist.

Die Nadelkühleinrichtung 21 ist über eine erste Dichteinrichtung D1 gegenüber dem Nadelkopf 10 abgedichtet und über eine zweite Dichteinrichtung D2 gegenüber der thermische Abschirmvorrichtung 20"".

Das Temperierungfluid TF tritt bei dieser Ausführungsform durch die erste Platte P1 von oben ein und wird durch die Probecard 5 über einen Einlass FI' und eine entsprechende (nicht gezeigte) Leitung zugeführt. Der erste Auslass FO' ist wie bei den anderen Ausführungsformen seitlich zwischen erster und zweiter Platte P1, P2. Der durch den Nadelkopf 10 geführte Teil des Temperierungsfluids TF entweicht nach ober durch die Probecard 5.

Weiterhin überdeckt die thermische Abschirmvorrichtung 20"" bei dieser Ausführungsform lateral lediglich die Probecard 5 und ist an dieser über eine Schraubeneinrichtung 12 befestigt. Ein Wärmeleitblech WB leitet das austretende Temperierungsfluid lateral weiter nach außen, damit es nicht mit dem Wafer W in Kontakt kommt.

Obwohl die vorliegende Erfindung vorstehend anhand bevorzugter Ausführungsformen erläutert wurde, ist sie nicht darauf beschränkt, sondern in vielfältiger Weise modifizierbar.

Insbesondere ist die geometrische Form der thermischen Abschirmvorrichtung nicht auf eine runde Form beschränkt, sondern kann eine beliebige Geometrie annehmen. Auch sind die angegebenen Materialien der thermischen Abschirmvorrichtung nur beispielhaft und können in breitem Umfang variiert werden.

Auch die geometrische Ausführung des Kanalsystems ist beliebig modifizierbar, wobei der Gegenstromverlauf zwar sehr effektiv, aber bei bestimmten Anwendungen nicht zwingend erforderlich ist. Auch ist die Anbringung der thermischen Abschirmvorrichtung an der Halterung der Probecard nicht zwingend erforderlich, sondern auch in anderer Weise vorstellbar, beispielsweise durch eine Aufhängung im unteren Bereich des Wafer-Probers.

Weiterhin lässt sich die PTC-Folienheizung alternativ oder zusätzlich auch auf der anderen Platte der Abschirmvorrichtung. Weiterhin sind die genannten Materialien der Abschirmvorrichtung nicht auf die beispielshalber angeführten Materialien beschränkt.

Der Schutzbereich der vorliegenden Erfindung ist durch die Ansprüche definiert.

## Patentansprüche

1. Thermische Abschirmvorrichtung (20"; 20'''; 20'''' für eine Probecard (5) mit:
einer ersten und zweiten wärmeleitfähigen Platte (P1, P2);
einer zwischen der ersten und zweiten wärmeleitfähigen Platte (P1, P2) vorgesehenen strukturierten wärmeisolierenden Zwischenschicht (Z), welche ein Kanalsystem (K) für ein Temperierungsfluid (TF) ausbildet, welches auf einer ersten Seite (S1) durch die erste Platte (P1) und auf einer zweiten Seite (S2) durch die zweite Platte (P2) begrenzt ist;
einem ersten Einlass (FI; FI') für das Temperierungsfluid (TF) in das Kanalsystem (K) und einem ersten Auslass (FO; FO') für das Temperierungsfluid (TF) aus dem Kanalsystem (K); und
einer Durchführungsöffnung (O; O'; O1) zum Durchführen eines auf der Probecard (5) angebrachten Nadelkopfes (10);
wobei die Zwischenschicht (Z) einen Kanal (K') zwischen der ersten und zweiten Platte (P1, P2) ausbildet, wobei ein zweiter Einlass (FI2) für das Temperierungsfluid (TF) in den Kanal (K') vorgesehen ist, wobei ein zweiter Auslass (FO2) für das Temperierungsfluid (TF) aus dem Kanal (K') vorgesehen ist und wobei der zweite Auslass (FO2) im Bereich der Durchführungsöffnung (O) derart vorgesehen ist, dass aus dem Kanal (K') austretendes Temperierungsfluid (TF) auf den Nadelkopf (10) richtbar ist.

2. Thermische Abschirmvorrichtung (20"; 20"'; 20"") nach Anspruch 1, wobei das Kanalsystem (K) derart gestaltet ist, dass das Temperierungsfluid (TF) darin einen Gegenstromverlauf annimmt.

3. Thermische Abschirmvorrichtung (20"; 20'''; 20'''') nach Anspruch 1, wobei der erste Einlass (FI) für das Temperierungsfluid (TF) und der erste Auslass (FO) für das Temperierungsfluid (TF) seitlich zwischen der ersten und zweiten Platte (P1, P2) in das Kanalsystem (K) geführt sind.

4. Thermische Abschirmvorrichtung (20"; 20'''; 20'''') nach Anspruch 1, wobei der erste Einlass (FI') für das Temperierungsfluid (TF) durch die erste Platte (P1) und der erste Auslass (FO') für das Temperierungsfluid (TF) seitlich zwischen der ersten und zweiten Platte (P1, P2) in das Kanalsystem (K) geführt sind.

5. Thermische Abschirmvorrichtung (20"; 20"'; 20'''') nach einem der vorhergehenden Ansprüche, wobei eine in die Durchführungsöffnung (O; O'; O1) einsetzbare Adaptervorrichtung (A) vorgesehen ist, welche eine weitere Durchführungsöffnung (OA) zum Durchführen des auf der Probecard (5) angebrachten Nadelkopfes (10) aufweist.

6. Thermische Abschirmvorrichtung (20"; 20"'; 20'''') nach einem der Ansprüche 1 bis 4, wobei eine in die Durchführungsöffnung (O; O'; O1) einsetzbare Nadelkühleinrichtung (21) vorgesehen ist, durch die das Temperierungsfluid (TF) teilweise in den Nadelkopf (10) einleitbar ist.

7. Thermische Abschirmvorrichtung (20"; 20'''; 20'''') nach einem der vorhergehenden Ansprüche, wobei die erste und zweite Platte (P1, P2) Metallplatten mit einer Dicke im Bereich 0,5 bis 2mm sind.

8. Thermische Abschirmvorrichtung (20"; 20'''; 20'''') nach einem der vorhergehenden Ansprüche, wobei die Zwischenschicht (Z) eine Gießharzschicht mit einer Dicke im Bereich 0,5 bis 2 mm ist.

9. Thermische Abschirmvorrichtung (20''; 20'''; 20'''') nach einem der vorhergehenden Ansprüche, wobei ein Temperatursensor (TS) in der Zwischenschicht (Z) angeordnet ist, der sich mit einer der ersten und zweiten Platte (P1; P2) in thermischem Kontakt befindet.

10. Thermische Abschirmvorrichtung (20''; 20'''; 20'''') nach einem der vorhergehenden Ansprüche, wobei auf einer der ersten und zweiten Platte (P1, P2) eine wärmeisolierende Abstandshaltervorrichtung (7) angebracht ist, welche auf die Probecard (5) zum Definieren eines dazwischenliegenden Luftspaltes (L) auflegbar ist.

11. Thermische Abschirmvorrichtung (20'', 20'''; 20'''' nach einem der vorhergehenden Ansprüche, wobei auf einer der ersten und zweiten Platte (P1, P2) eine PCT-Folienheizung (FH) aufgebracht ist.

12. Probecardanordnung mit einer Probecard (5) und einer thermischen Abschirmvorrichtung (20"; 20'''; 20'''') nach Anspruch 1, wobei die thermische Abschirmvorrichtung (20"; 20'''; 20'''') durch einen Luftspalt (L) von der Probecard (5) beabstandet die Probecard (5) überdeckend vorgesehen ist und wobei der Nadelkopf (10) durch eine Dichteinrichtung (25; 25") abgedichtet durch die Durchführungsöffnung (O; O'; O1) geführt ist.

13. Probecardanordnung nach Anspruch 12, wobei die Dichteinrichtung (25") derart gestaltet ist, dass aus dem zweiten Auslass (FO2) austretendes Temperierungsfluid (TF) zu einer Nadeleinrichtung (10a) des Nadelkopfes (10) hin abgedichtet ist.

14. Probecardanordnung nach Anspruch 12, wobei eine in die Durchführungsöffnung (O; O'; O1) einsetzbare Adaptervorrichtung (A) vorgesehen ist, welche eine weitere Durchführungsöffnung (OA) zum Durchführen des auf der Probecard (5) angebrachten Nadelkopfes (10) aufweist, wobei die Adaptervorrichtung (A) durch eine erste Dichteinrichtung (26; 26a, 26b) abgedichtet in die Durchführungsöffnung (O; O'; O1) eingesetzt ist und wobei der Nadelkopf (10) durch eine zweite Dichteinrichtung (25; 25''') abgedicht durch die weitere Durchführungsöffnung (OA) geführt ist.

15. Probecardanordnung nach Anspruch 14, wobei der zweite Auslass (FO2) im Bereich der Durchführungsöffnung (O'; O1) derart vorgesehen ist, dass aus dem durchgehenden Kanal (K') austretendes Temperierungsfluid über einen weiteren Kanal (K") in der Adaptervorrichtung (A) auf den Nadelkopf (10) richtbar ist und wobei die erste Dichteinrichtung (26a, 26b) und die zweite Dichteinrichtung (25''') derart gestaltet sind, dass aus dem zweiten Auslass (FO2) und aus dem zweiten Kanal (K") austretendes Temperierungsfluid (TF) zu einer Nadeleinrichtung (10a) des Nadelkopfes (10) hin abgedichtet ist.

16. Probecardanordnung nach einem der Ansprüche 12 bis 15, wobei die Probecard (5) in eine Halterung (2) eingespannt ist und wobei die thermische Abschirmvorrichtung (20; 20'; 20"; 20"'; 20'''') an der Halterung (2) angebracht ist.

17. Probecardanordnung nach einem der Ansprüche 12 bis 15, wobei auf einer der Probecard (5) gegenüberliegenden Seite der thermische Abschirmvorrichtung (20"; 20"'; 20'''') ein temperierbarer Chuck (CH) vorgesehen ist, welcher bezüglich des Nadelkopfes (10) seitlich verfahrbar ist, wobei die thermische Abschirmvorrichtung (20"; 20'''; 20'''') derart dimensioniert ist, dass sie die Probecard (5) über einen entsprechenden Verfahrbereich thermisch abschirmt.

## Claims

1. Thermal shielding device (20'', 20'''; 20'''') for a probe card (5) with:
a first and second thermally conductive plate (P1, P2);
a structured thermally-insulating intermediate layer (Z) between the first and second thermally conductive plate (P1, P2), providing a channel system (K) for a temperature-conditioning fluid (TF) which is delimited on a first side (S1) by means of the first plate (P1) and on a second side (S2) by means of the second plate (P2);
a first inlet (Fl; FI') into the channel system (K) for the temperature-conditioning fluid (TF) and a first outlet (FO;
FO') from the channel system (K) for the temperature-conditioning fluid (TF); and
a through-opening (0; 0'; 01) for passing a needle head (10) through which is attached to the probe card (5);
wherein the intermediate layer (Z) provides a channel (K') between the first and second plates (P1, P2), wherein a second inlet (FI2) into the channel (K') is provided for the temperature-conditioning fluid (TF), wherein a second outlet (F02) is provided from the channel (K') for the temperature-conditioning fluid (TF) and wherein the second outlet (F02) is provided in the region of the through-opening (0) such that temperature-conditioning fluid (TF) exiting from the channel (K') can be directed on to the needle head (10).

2. Thermal shielding device (20''; 20''' ; 20'''') according to claim 1, wherein the channel system (K) is designed such that the temperature-conditioning fluid (TF) takes a counterflow path therein.

3. Thermal shielding device (20''; 20''' ; 20'''') according to claim 1, wherein the first inlet (F1) for the temperature-conditioning fluid (TF) and the first outlet (FO) for the temperature-conditioning fluid (TF) are guided laterally between the first and second plates (P1, P2) into the channel system (K).

4. Thermal shielding device (20''; 20'''; 20'''') according to claim 1, wherein the first inlet (FI') for the temperature-conditioning fluid (TF) is guided through the first plate (P1) and the first outlet (FO') for the temperature-conditioning fluid (TF) is guided laterally between the first and second plates (P1, P2) into the channel system (K) .

5. Thermal shielding device (20''; 20''' ; 20'''') according to any one of the preceding claims, wherein an adapter device (A) has can be inserted into the through-opening (0; 0'; 01) has an additional through-opening (OA) for passing the needle head (10) through which is attached to the probe card (5) .

6. Thermal shielding device (20''; 20''' ; 20'''') according to any one of claims 1 to 4, wherein a needle-cooling device (21) is provided which can be inserted into the through-opening (0; 0'; 01), through which needle-cooling device (21) the temperature-conditioning fluid (TF) can be partially introduced into the needle head (10).

7. Thermal shielding device (20''; 20''' ; 20'''') according to any one of the preceding claims, wherein the first and second plates (P1, P2) are metal plates with a thickness in the region of 0.5 to 2mm.

8. Thermal shielding device (20''; 20'''; 20'''') according to any one of the preceding claims, wherein the intermediate layer (Z) is a casting resin layer with a thickness in the region of 0.5 to 2mm.

9. Thermal shielding device (20''; 20'''; 20'''') according to any one of the preceding claims, wherein a temperature sensor (TS) is arranged in the intermediate layer (Z) and is in thermal contact with any one of the first and second plates (P1; P2).

10. Thermal shielding device (20''; 20'''; 20'''') according to any one of the preceding claims, wherein a thermally insulating spacer device (7) is attached to any one of the first and second plates (P1, P2) and can be placed on to the probe card (5) for defining an intermediate air gap (L).

11. Thermal shielding device (20''; 20'''; 20'''') according to any one of the preceding claims, wherein a PCT film heater (FH) is attached to any one of the first and second plates (P1, P2).

12. Probe card assembly with a probe card (5) and a thermal shielding device (20''; 20'''; 20'''') according to claim 1, wherein the thermal shielding device (20''; 20'''; 20'''') which is remote from the probe card (5) by means of an air gap (L) is provided overlapping said probe card (5) and wherein the needle head (10), which is insulated by means of an insulation device (25; 25''), is guided through the through-opening (0; 0'; 01).

13. Probe card assembly according to claim 12, wherein the insulating device (25'') is designed such that temperature-conditioning fluid (TF) exiting from the second outlet (F02) is insulated in the direction of a needle device (10a) of the needle head (10).

14. Probe card assembly according to claim 12, wherein an adapter device (A) can be inserted into the through-opening (0; 0'; 01) and has an additional through-opening (OA) for feeding the needle head (10) through which is attached to the probe card (5), wherein the adapter device (A) insulated by means of a first insulating device (26; 26a, 26b) is inserted into the through-opening (0; 0'; 01) and wherein the needle head (10) insulated by means of a second insulating device (25; 25''') is guided through the additional through-opening (OA).

15. Probe card assembly according to claim 14, wherein the second outlet (F02) in the region of the through-opening (0'; 01) is provided such that temperature-conditioning fluid exiting from the continuous channel (K') can be directed via an additional channel (K'') in the adapter device (A) on to the needle head (10) and wherein the first insulating device (26a, 26b) and the second insulating device (25''') are designed such that temperature-conditioning fluid (TF) exiting from the second outlet (F02) and from the second channel (K'') is insulated in the direction of a needle device (10a) of the needle head (10).

16. Probe card assembly according to any one of claims 12 to 15, wherein the probe card (5) is clamped in a holding means (2) and wherein the thermal shielding device (20; 20'; 20''; 20'''; 20'''') is attached to the holding means (2).

17. Probe card assembly according to any one of claims 12 to 15, wherein on a side of the thermal shielding device (20''; 20'''; 20'''') opposing the probe card (5) a temperature-controllable chuck (CH) is provided which can be moved laterally in respect of the needle head (10), wherein the thermal shielding device (20''; 20'''; 20'''') is dimensioned such that it thermally shields the probe card (5) across a corresponding range of movement.

## Revendications

1. Dispositif de blindage thermique (20'' ; 20''' ; 20'''') pour une carte de sonde (5) doté :
d'une première et d'une deuxième plaque thermoconductrice (P1, P2) ;
d'une couche intermédiaire (Z) structurée calorifuge prévue entre la première et la deuxième plaque thermoconductrice (P1, P2), laquelle forme un système de canal (K) pour un fluide thermorégulateur (TF), lequel est délimité d'un premier côté (S1) par la première plaque (P1) et d'un deuxième côté (S2) par la troisième plaque (P2) ;
d'une première admission (FI ; FI') pour que le fluide thermorégulateur (TF) entre dans le système de canal (K) et d'une première évacuation (FO ; FO') pour que le fluide thermorégulateur (TF) sorte du système de canal (K) ; et
d'une ouverture de passage (0 ; 0' ; 01) pour le passage d'une tête d'aiguille (10) arrangée sur la carte de sonde (5) ;
dans lequel la couche intermédiaire (Z) forme un canal (K') entre la première et la deuxième plaque (P1, P2), dans lequel une deuxième admission (FI2) est prévue pour que le fluide thermorégulateur (TF) entre dans le canal (K'), dans lequel une deuxième évacuation (F02) est prévue pour que le fluide thermorégulateur (TF) sorte du canal (K') et dans lequel la deuxième évacuation (F02) est prévue dans la zone de l'ouverture de passage (0) de telle sorte que le fluide thermorégulateur (TF) sortant du canal (K') peut être dirigé sur la tête d'aiguille (10).

2. Dispositif de blindage thermique (20'' ; 20''' ; 20'''') selon la revendication 1, dans lequel le système de canal (K) est configuré de telle sorte que le fluide thermorégulateur (TF) y adopte un parcours à contre-courant.

3. Dispositif de blindage thermique (20'' ; 20''' ; 20'''') selon la revendication 1, dans lequel la première admission (FI) pour le fluide thermorégulateur (TF) et la première évacuation (FO) pour le fluide thermorégulateur (TF) sont guidées latéralement dans le système de canal (K) entre la première et la deuxième plaque (P1, P2).

4. Dispositif de blindage thermique (20'' ; 20''' ; 20'''') selon la revendication 1, dans lequel la première admission (FI') pour le fluide thermorégulateur (TF) est guidée à travers la première plaque (P1) et la première évacuation (FO') pour le fluide thermorégulateur (TF) est guidée latéralement dans le système de canal (K) entre la première et la deuxième plaque (P1, P2).

5. Dispositif de blindage thermique (20'' ; 20''' ; 20'''') selon l'une des revendications précédentes, dans lequel un dispositif adaptateur (A) insérable dans l'ouverture de passage (0 ; 0' ; 01) est prévu, lequel comporte une ouverture de passage supplémentaire (OA) pour le passage de la tête d'aiguille (10) arrangée sur la carte de sonde (5).

6. Dispositif de blindage thermique (20'' ; 20''' ; 20'''') selon l'une des revendications 1 à 4, dans lequel un moyen de refroidissement de l'aiguille (21) insérable dans l'ouverture de passage (0 ; 0' ; 01) est prévu, à travers lequel le fluide thermorégulateur (TF) peut être introduit partiellement dans la tête d'aiguille (10).

7. Dispositif de blindage thermique (20'' ; 20''' ; 20'''') selon l'une des revendications précédentes, dans lequel la première et la deuxième plaque (P1, P2) sont des plaques métalliques d'une épaisseur dans un intervalle de 0,5 à 2 mm.

8. Dispositif de blindage thermique (20'' ; 20''' ; 20'''') selon l'une des revendications précédentes, dans lequel la couche intermédiaire (Z) est une couche de résine de coulée d'une épaisseur dans un intervalle de 0,5 à 2 mm.

9. Dispositif de blindage thermique (20'' ; 20''' ; 20'''') selon l'une des revendications précédentes, dans lequel un capteur de température (TS) est agencé dans la couche intermédiaire (Z), lequel se trouve en contact thermique avec la première et la deuxième plaque (P1, P2).

10. Dispositif de blindage thermique (20'' ; 20''' ; 20'''') selon l'une des revendications précédentes, dans lequel un dispositif espaceur calorifuge (7) est arrangé sur l'une parmi la première et la deuxième plaque (P1, P2), lequel peut être disposé sur la carte de sonde (5) pour définir un interstice d'air (L) entre celles-ci.

11. Dispositif de blindage thermique (20'' ; 20''' ; 20'''') selon l'une des revendications précédentes, dans lequel une pellicule chauffante à coefficient thermique positif (FH) est arrangée sur l'une parmi la première et la deuxième plaque (P1, P2).

12. Système de carte de sonde doté d'une carte de sonde (5) et d'un dispositif de blindage thermique (20'' ; 20''' ; 20'''') selon la revendication 1, dans lequel le dispositif de blindage thermique (20'' ; 20''' ; 20'''') est prévu comme recouvrant la carte de sonde (5) et écarté de la carte de sonde (5) par un interstice d'air (L) et dans lequel la tête d'aiguille (10) est guidée à travers l'ouverture de passage (0 ; 0' ; 01) de manière étanche grâce à un moyen d'étanchéité (25 ; 25'').

13. Système de carte de sonde selon la revendication 12, dans lequel le moyen d'étanchéité (25 ; 25'') est configuré de telle sorte que le fluide thermorégulateur (TF) sortant de la deuxième évacuation (F02) est scellé à un moyen d'aiguille (10a) de la tête d'aiguille (10).

14. Système de carte de sonde selon la revendication 12, dans lequel un dispositif adaptateur (A) insérable dans l'ouverture de passage (0 ; 0' ; 01) est prévu, lequel comporte une ouverture de passage supplémentaire (OA) pour le passage de la tête d'aiguille (10) arrangée sur la carte de sonde (5), dans lequel le dispositif adaptateur (A) est inséré dans l'ouverture de passage (0 ; 0' ; 01), de manière étanche grâce à un premier moyen d'étanchéité (26 ; 26a, 26b) et dans lequel la tête d'aiguille (10) est guidée à travers l'ouverture de passage supplémentaire (OA) de manière étanche grâce à un deuxième moyen d'étanchéité (25 ; 25'').

15. Système de carte de sonde selon la revendication 14, dans lequel la deuxième évacuation (F02) est prévue dans la zone de l'ouverture de passage (0' ; 01) de telle sorte que le fluide thermorégulateur sortant du canal traversant (K') peut être dirigé sur la tête d'aiguille (10) dans le dispositif adaptateur (A) par le biais d'un canal supplémentaire (K'') et dans lequel le premier moyen d'étanchéité (26a, 26b') et le deuxième moyen d'étanchéité (25'') sont configurés de telle sorte que le fluide thermorégulateur (TF) sortant de la deuxième évacuation et du deuxième canal (K'') est scellé à un moyen d'aiguille (10a) de la tête d'aiguille (10).

16. Système de carte de sonde selon l'une des revendications 12 à 15, dans lequel la carte de sonde (5) est serrée dans un support (2) et dans lequel le dispositif de blindage thermique (20 ; 20' ; 20'' ; 20''' ; 20'''') est arrangé sur le support (2).

17. Système de carte de sonde selon l'une des revendications 12 à 15, dans lequel un mandrin thermorégulable (CH) est prévu sur un côté du dispositif de blindage thermique (20'' ; 20''' ; 20'''') opposé à la carte de sonde (5), lequel peut être déplacé latéralement par rapport à la tête d'aiguille (10), dans lequel le dispositif de blindage thermique (20'' ; 20''' ; 20'''') est dimensionné de telle sorte qu'il protège thermiquement la carte de sonde (5) par le biais d'une plage de déplacement correspondante.
